# FASCICULE DE BREVET EUROPEEN

(11) **EP 0 579 562 B1**
(45) Date de publication et mention de la délivrance du brevet: **21.01.1998**
(21) Numéro de dépôt: 93420293.8
(22) Date de dépôt: 05.07.1993
(51) Int. Cl.: H01L 21/00, B25B 7/02

(54) **Outil de préhension de nacelles pour plaquettes de silicium**
Greifvorrichtung für Halter für Silizum-Plättchen
Gripping device for holders of silicium discs

(30) Priorité: 08.07.1992 FR 9208818
(43) Date de publication de la demande: 19.01.1994
(73) Titulaire: SGS-THOMSON MICROELECTRONICS S.A., 94250 Gentilly (FR)
(72) Inventeur: Brou, Bruno, F-37000 Tours (FR)
(74) Mandataire: de Beaumont, Michel

(56) Documents cités:
- EP-A- 0 207 823
- WO-A-80/00073
- DE-U- 7 911 899
- US-A- 1 667 934
- US-A- 3 790 203
- US-A- 5 023 989
- US-A- 5 036 733

## Description

La présente invention concerne un outil de préhension de nacelles pour plaquettes de silicium, en particulier de nacelles en quartz, ou autre matériau, que l'on doit exclusivement toucher avec des parties du même matériau que les nacelles afin de ne pas les polluer.

Au cours de certains traitements de plaquettes de silicium, celles-ci sont disposées dans des nacelles en un matériau, tel que du quartz, ne risquant pas de polluer les plaquettes lors des traitements. Afin de ne pas polluer les nacelles elles-mêmes, celles-ci doivent être manipulées par des outils dont les parties venant en contact avec les nacelles sont recouvertes de quartz.

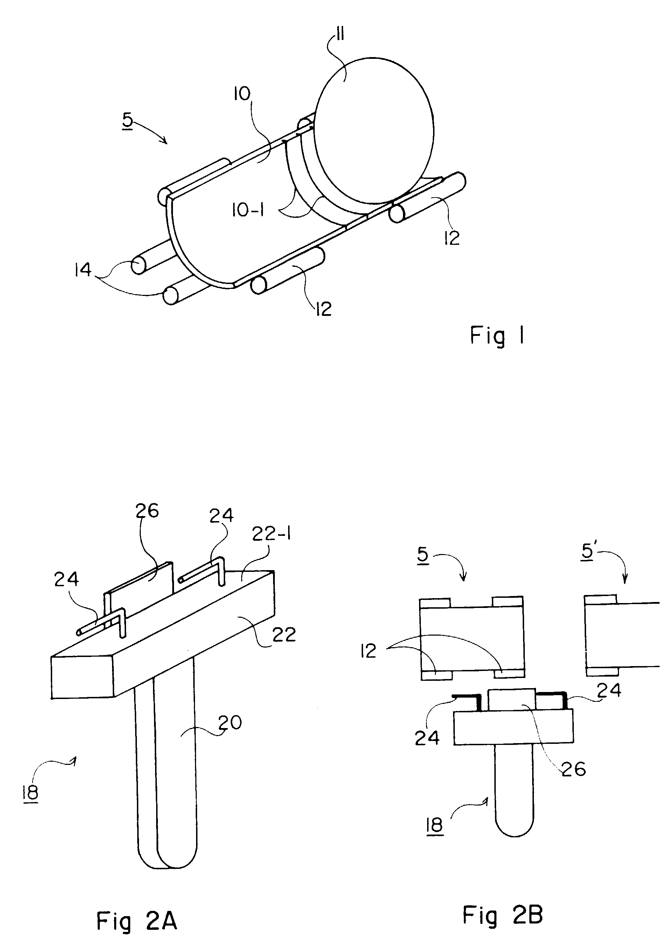

La figure 1 représente un type particulier de nacelle classique 5 en quartz, auquel s'applique l'invention. Cette nacelle comprend une paroi 10 constituée d'une portion de cylindre de révolution dont la surface concave est dirigée vers le haut. Cette surface concave est munie de rainures circonférentielles 10-1 servant chacune à maintenir une plaquette en silicium 11 perpendiculairement à l'axe de la paroi cylindrique 10 (on n'a représenté que trois rainures et une plaquette). Deux tubes 12 écartés et alignés parallèlement à l'axe de la paroi cylindrique 10 sont soudés sur chacun des deux bords axiaux de la paroi cylindrique. Comme on le verra ci-après, les tubes 12 servent à la manipulation de la nacelle.

Pour un traitement, par exemple dans un four de diffusion, plusieurs nacelles sont disposées à la queue leu leu, par exemple sur une paire de rails 14 longitudinaux. Comme cela est représenté, ces rails 14 sont proches l'un de l'autre par rapport à la dimension transversale de la paroi 10. Les nacelles comprennent aussi parfois des pieds, sous la forme de tubes soudés, au même niveau environ que les rails 14.

La figure 2A représente une vue en perspective d'un outil classique de préhension d'une nacelle du type de celle de la figure 1. Cet outil, désigné de façon générale par la référence 18, comprend un manche 20 et une barre perpendiculaire 22 à section rectangulaire solidaire du manche. Une face 22-1 de la barre 22, du côté opposé du manche 10, est munie de deux tiges coudées 24. Les tiges coudées 24 sont solidaires du bras 22 respectivement à proximité des extrémités de celui-ci et s'étendent d'abord perpendiculairement à la face 22-1 puis parallèlement à la face 22-1 vers une même extrémité de la barre 22. Les parties des tiges 24 parallèles à la face 22-1 sont munies d'embouts en quartz non représentés. Une plaquette de maintien en quartz 26, solidaire de la barre 22, est disposée parallèlement aux tiges 24 en déport par rapport à celles-ci.

La figure 2B illustre schématiquement l'outil 18 en position au voisinage d'une nacelle 5. Pour prendre une nacelle, les extrémités des tiges 24 de l'outil 18 sont glissées dans deux tubes alignés 12 de la nacelle, l'outil étant orienté de sorte que la plaquette 26 se trouve du côté inférieur de l'outil. Ensuite, l'outil est basculé vers le bas autour de l'axe défini par les tubes 12 de sorte que la plaquette 26 vienne buter contre la partie inférieure de la nacelle. Les rails 14, ou des éventuels pieds de la nacelle, sont situés de telle façon que la plaquette 26 vient buter sur la paroi 10 sans être gênée par les rails ou les pieds. La nacelle est alors suffisamment maintenue pour qu'elle puisse être soulevée.

Au début de cette opération, les tiges 24 sont placées devant des ouvertures respectives des deux tubes 12, l'une des tiges 24 étant placée entre les deux tubes et l'autre tige 24 étant placée entre un tube de la nacelle à prendre 5 et un tube adjacent d'une éventuelle nacelle adjacente 5'. Ainsi, si l'on veut pouvoir prendre une nacelle située entre deux nacelles adjacentes, il faut que la distance séparant la nacelle à prendre d'une nacelle adjacente permette le passage d'une tige 24 entre les deux tubes 12 adjacents. Ceci n'est généralement pas le cas et il faut commencer par écarter les nacelles voisines de celle qu'on souhaite prendre pour pouvoir mettre en position l'outil 18.

En outre, si un opérateur, au cours d'une manipulation, incline l'outil 18 de sorte à diriger les extrémités des tiges 24 vers le bas, la nacelle transportée risque de glisser et tomber.

Le document WO-A-8 000 073 décrit un outil de préhension de nacelles. Un outil de préhension selon le préambule de la revendication 1 est connu de US-A-1 667 934 et de US-A-5 023 989. Un outil comprenant un doigt coulissant est décrit dans les documents DE-U-7 911 899 et US-A-3 790 203.

Un objet de la présente invention est de prévoir un outil de préhension de nacelles du type à tubes de manipulation, qui permette de prendre directement une nacelle située entre deux nacelles adjacentes rapprochées.

Un autre objet de la présente invention est de prévoir un tel outil permettant de maintenir une nacelle de manière fiable.

Ces objets sont atteints grâce à un outil de préhension d'objets munis d'au moins un couple d'ouvertures écartées et se faisant face. L'outil comprend deux bras articulés l'un sur l'autre formant deux leviers courts adjacents, et deux leviers longs adjacents ; et deux tiges solidaires respectivement des extrémités des leviers courts, s'étendant dans un plan parallèle au plan des bras sensiblement dans des directions opposées. Cet outil comprend un doigt coulissant dans le sens longitudinal dans un plan parallèle au plan des bras, et deux biellettes articulées sur une extrémité du doigt et respectivement sur les leviers longs, les deux biellettes formant un angle dont le sommet est dirigé vers l'axe d'articulation des bras.

Selon un mode de réalisation de la présente invention, les bras sont articulés sans se croiser de manière que les leviers courts s'écartent lorsque les leviers longs sont ramenés l'un vers l'autre, un ressort étant disposé pour écarter les leviers longs l'un de l'autre.

Selon un mode de réalisation de la présente invention, lesdits objets à prendre sont des nacelles munies d'au moins un couple de tubes alignés et écartés formant lesdites ouvertures.

Selon un mode de réalisation de la présente invention, les extrémités desdites deux tiges et du doigt sont munies d'embouts en quartz.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1, précédemment décrite, représente une nacelle classique de traitement et de transport de plaquettes de silicium ;
la figure 2A, précédemment décrite, illustre une vue en perspective d'un outil classique de préhension de nacelles du type de la figure 1 ;
la figure 2B, précédemment décrite, illustre schématiquement comment se servir de l'outil de la figure 2A ; et
la figure 3 illustre une vue en perspective d'un mode de réalisation d'un outil de préhension selon l'invention d'une nacelle du type de celle de la figure 1.

Un outil selon l'invention se présente sous la forme d'une pince à main. Pour prendre une nacelle, deux tiges solidaires d'une extrémité de la pince sont insérées dans l'espace entre deux tubes alignés de la nacelle, puis écartées, par la manipulation de deux bras de la pince, de sorte qu'elles pénètrent dans les tubes. En même temps que les tiges sont écartées, un doigt, déplacé par le mouvement des bras de la pince, vient buter contre la partie inférieure de la nacelle pour maintenir celle-ci par gravité.

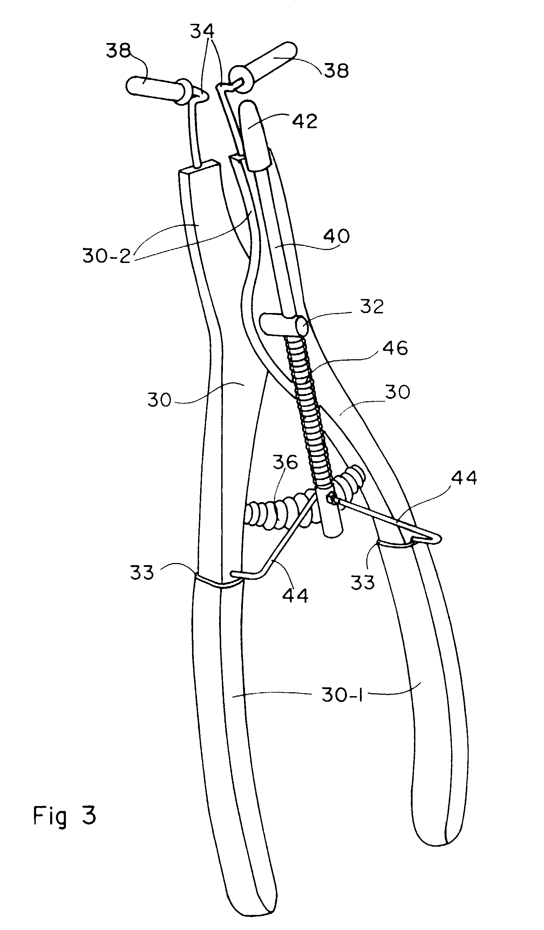

Le mode de réalisation d'outil de préhension de nacelle selon l'invention représenté à la figure 3 présente l'allure d'une pince à retirer des circlips intérieurs et peut d'ailleurs être réalisé facilement à partir d'une pince classique. Deux bras 30 sont articulés autour d'un axe 32 sans se croiser, c'est-à-dire que lorsque les bras sont rapprochés l'un vers l'autre d'un côté de l'axe 32, ils s'écartent l'un de l'autre de l'autre côté de l'axe. D'un côté de l'axe 32, les bras 30 forment des leviers longs 30-1 de manipulation de l'outil et présentent, comme cela est classique pour une pince à main, une forme courbe pour faciliter la prise de l'outil. En outre, ces leviers longs peuvent être entourés, comme cela est représenté, de gaines antidérapantes 33. De l'autre côté de l'axe 32, les bras 30 forment des leviers courts 30-2 dont les extrémités sont munies de tiges 34.

Les tiges 34 s'étendent d'abord dans le prolongement des leviers courts, puis s'écartent l'une de l'autre dans un même plan parallèle au plan des bras 30. Comme cela est représenté, les tiges 34 peuvent comprendre des parties intermédiaires coudées parallèlement à l'axe 32, ce qui permet de leur conférer davantage de flexibilité et de fixer avec précision la position des parties extrêmes des tiges 34 par rapport à un doigt escamotable, décrit ultérieurement, jouant le rôle de la plaquette de maintien 26 de l'outil classique de la figure 2A.

La position représentée à la figure 3 est une position de repos de l'outil où les tiges 34 peuvent être insérées entre deux tubes alignés 12 d'un bord d'une nacelle du type de celle de la figure 1. Un ressort 36, prévu classiquement dans une pince à circlips, s'appuie entre les deux leviers longs 30-1 et sollicite l'outil vers la position de repos. Dans cette position, comme cela est représenté, les parties extrêmes des tiges 34 forment entre elles un angle obtus dont le sommet est dirigé vers l'axe 32. Ainsi, en serrant les leviers longs 30-1, les parties extrêmes des tiges 34 s'écartent et tendent à s'aligner entre elles pour faciliter la pénétration dans les tubes 12. L'élasticité des tiges 34 permet aux parties extrêmes des tiges de rester en alignement avec les tubes 12 pour que ces parties extrêmes puissent continuer à pénétrer dans les tubes. Comme cela est représenté, les parties extrêmes des tiges 34 sont munies d'embouts 38, de préférence en quartz. Ces embouts 38 comprennent des épaulements respectifs qui définissent la position finale de la pince en venant buter contre des extrémités des tubes 12 correspondants.

En outre, comme cela est représenté, l'axe 32 comprend un prolongement muni d'un perçage perpendiculaire dans lequel coulisse un doigt 40. Le doigt 40 coulisse dans le sens longitudinal de la pince et son extrémité du côté des tiges 34 est destinée à venir buter contre la partie inférieure de la nacelle manipulée pour maintenir celle-ci par gravité. Cette extrémité est également munie d'un embout en quartz 42. A l'autre extrémité du doigt 40 sont articulés des premières extrémités de deux biellettes 44. Les deuxièmes extrémités des biellettes 44 sont respectivement articulées sur les leviers longs 30-1. Les biellettes 44 forment un angle dont le sommet est dirigé vers l'axe 32. Avec cette configuration, lorsque les leviers longs sont serrés, le doigt 40 est poussé par les biellettes 44 vers la nacelle en même temps que les tiges 34 sont écartées. On pourra prévoir un ressort 46 enroulé autour du doigt 40 et s'appuyant entre l'axe 32 et les biellettes 44 pour aider le ressort 36 à ramener la pince dans la position de repos représentée.

Pour prendre une nacelle avec une pince selon l'invention, on place la pince sensiblement horizontalement de sorte que le doigt 40 se trouve sous la pince, on insère les tiges 34 entre deux tubes 12 d'une nacelle seule ou disposée entre deux autres nacelles, et on serre la pince. Lors du serrage, les tiges 34 pénètrent dans les tubes 12 et le doigt 40 vient buter contre la partie inférieure de la nacelle. La nacelle peut alors être prise et transportée de manière sûre en gardant la pince serrée.

De nombreuses variantes et modifications d'une pince selon l'invention apparaîtront à l'homme du métier. Par exemple, on peut prévoir que la pince présente une position de repos où les tiges 34 sont en position écartée et le doigt 40 en position de maintien de nacelle ; il suffit pour cela que les bras 30 soient articulés en se croisant. Pour utiliser une telle pince, on la serre pour insérer les tiges 34 entre deux tubes 12, puis on la libère pour qu'elle retrouve sa position de repos qui est aussi une position de maintien de nacelle.

Une pince selon l'invention peut s'appliquer à d'autres objets à manipuler, pourvu que ceux-ci soient munis de deux ouvertures écartées et se faisant face.

## Revendications

1. Outil de préhension d'objets (5) munis d'au moins un couple d'ouvertures (12) écartées et se faisant face, comprenant
- deux bras (30) articulés l'un sur l'autre formant deux leviers courts (30-2) ) adjacents et deux leviers longs (30-1) adjacents ; et
- deux tiges (34) solidaires respectivement des extrémités des leviers courts, s'étendant dans un plan parallèle au plan des bras leurs extrémités s'écartant dans des directions opposées ;
caractérisé en ce qu'il comprend en outre :
- un doigt de maintien (40) coulissant dans le sens longitudinal de l'outil dans un plan parallèle au plan des bras (20) et décalé par rapport à celui-ci ; et
- deux biellettes (44) articulées sur une extrémité du doigt et respectivement sur les leviers longs (30-1), les deux biellettes formant un angle dont le sommet est dirigé vers l'axe (32) d'articulation des bras.

2. Outil selon la revendication 1, caractérisé en ce que les bras (30) sont articulés sans se croiser de manière que les leviers courts (30-2) s'écartent lorsque les leviers longs (30-1) sont ramenés l'un vers l'autre, un ressort (36) étant disposé pour écarter les leviers longs l'un de l'autre.

3. Outil selon la revendication 2, caractérisé en ce que les extrémités desdites deux tiges (34) et du doigt (40) sont munies d'embouts en quartz.

4. Utilisation de l'outil selon la revendication 1, caractérisé en ce que lesdits objets à prendre sont des nacelles (5) munies d'au moins un couple de tubes (12) alignés et écartés formant lesdites ouvertures.

## Patentansprüche

1. Greifwerkzeug zum Ergreifen von Gegenständen (5), die mit wenigstens einem Paar einander in Abstand gegenüberstehender Öffnungen versehen sind, wobei das Werkzeug umfaßt:
- zwei miteinander gelenkig so verbundene Arme (30), daß sie miteinander zwei benachbarte kurze Hebel (30-2) und zwei benachbarte lange Hebel (30-1) bilden;
- zwei jeweils mit den freien Enden der kurzen Hebel verbundene, sich in der Ebene der Arme erstreckende Stäbe bzw. Stengel (34), deren Enden sich in entgegengesetzter Richtung voneinander weg erstrecken;
**dadurch gekennzeichnet,** daß das Werkzeug des weiteren umfaßt:
- einen Halte- bzw. Stützfinger (40), der in Längsrichtung des Werkzeugs in einer zur Ebene der Arme parallelen und gegenüber dieser versetzten Ebene gleitend verschieblich ist; sowie
- zwei jeweils mit dem einen Ende des Gleitfingers bzw. mit den langen Hebeln (30-1) gelenkig verbundene Gelenkstangen (44), die mit einander einen Winkel bilden, dessen Scheitel der Schwenkachse (32) der Arme zugewandt ist.

2. Werkzeug nach Anspruch 1, dadurch gekennzeichnet, daß die Arme (30) ohne sich zu überkreuzen miteinander gelenkig verbunden sind, derart, daß die kurzen Hebel (30-2) auseinandergespreizt werden, wenn die langen Hebel aufeinanderzu bewegt werden, wobei eine Feder (36) zur Auseinanderspreizung der langen Hebel (30-1) vorgesehen ist.

3. Werkzeug nach Anspruch 2, dadurch gekennzeichnet, daß die Enden der beiden Stengelstangen (34) und des Gleitfingers (40) mit Umhüllungen aus Quartz versehen sind.

4. Verwendung des Werkzeugs nach Anspruch 1, dadurch gekennzeichnet, daß die zu ergeifenden Gegenstände Schiffchen (5) sind, die mit wenigstens einem Paar von in Abstand von einander angeordneten, miteinander ausgerichteten Röhren (12) versehen sind, welche die genannten Öffnungen bilden.

## Claims

1. A tool for gripping objects (5) provided with at least one pair of apertures (12) spaced apart and facing each other, including:
- two articulated arms (30) forming two short adjacent levers (30-2) and two long adjacent levers (30-1); and
- two rods (34) integral, respectively, -with the ends of the short levers, extending in a plane parallel to the plane of the arms, their ends separating in opposite directions ;
characterized in that it further includes :
- a finger (40) sliding along the longitudinal direction of the tool in a plane parallel to the plane of the arms (30); and
- two links (44) articulated on one end of the finger and respectively on the long levers (30-1), said two links forming an angle whose apex faces the articulation axis (32) of the arms.

2. The gripping tool of claim 1, wherein said arms (30) are articulated but do not cross each other so that the short levers (30-2) are separated from each other when the long levers (30-1) are drawn closer, a spring (36) being arranged to urge apart the long levers.

3. The gripping tool of claim 2, wherein said objects to be gripped are wafer-supporting boats (5) provided with at least one pair of tubes (12) that are aligned and spaced apart, forming said apertures.

4. The gripping tool of claim 3, wherein the ends of said two rods (34) and of the finger (40) are provided with quartz sleeves.
